# EUROPEAN PATENT APPLICATION

(11) **EP 2 326 034 A1**
(43) Date of publication of application: **25.05.2011**
(21) Application number: 09174143.9
(22) Date of filing: 27.10.2009
(51) Int. Cl.: H04H 60/04, H03G 3/30

(54) **Audio console with direct out gain stabiliser**

(71) Applicant: Harman International Industries Ltd., Potters Bar Hertfordshire EN6 3JN (GB)
(72) Inventor: Ayres, Richard, Welwyn Garden City, AL73SR (GB)
(74) Representative: Bertsch, Florian Oliver

(57) **Abstract**

The invention relates to an audio console processing audio signals comprising:
- at least one input receiving an audio signal,
- an adjustable input amplifier amplifying the audio signal received from said at least one input,
- a direct out output provided downstream of the adjustable input amplifier for outputting a direct out output signal,
- a direct out output amplifier provided upstream of the direct out output and downstream of the adjustable input amplifier for adjusting a gain of the direct out output signal, wherein the direct output amplifier is configured in such a way, that, upon an adjustment of the adjustable input amplifier, the direct out output amplifier adjusts the gain of the direct out output signal inversely to the adjustment of the input amplifier resulting in an unchanged gain of the audio signal from the said at least one input to the direct out output.

## Description

This invention relates to an audio console processing audio signals and to a console system with a master console and a slave console and to a method for processing an audio signal.

### Related Art

With the increasing use of digital consoles there is a growing need for multiple mixing consoles to share a single microphone amplifier. In the analogue domain this was typically achieved with an analogue splitting system resulting in an independent microphone amplifier in each console. In a digital mixing console the typical architecture does not accommodate this and the microphone amplifier has to be shared. This sharing of the microphone amplifier causes conflict, as audio engineers are uncomfortable that one operator may increase or decrease the microphone amplifier gain thereby affecting the levels and mixes on other consoles within the system. Furthermore, it is desirable to reduce project costs of both infrastructure/installation and equipment whilst increasing system flexibility. In these environments a sharing common resource is a growing requirement.

Over and above the traditional analogue split solutions the solution exists to incorporate multiple microphone amplifiers that may be accessed independently by different mixing consoles. However, this solution is expensive. Another solution would be that changes to the gain of a console A are detected by a console B that applies the inverse gain change to its digital trim resulting in a net "no change" to the level in the console B. However, in this embodiment console A needs to communicate with console B. However, this means that console B has to be able to understand console A which is normally only the case if the two consoles are supplied by a common supplier.

Accordingly, a need exists to provide an audio console allowing to share a single microphone amplifier while avoiding that an adjustment of the microphone signal in one console influences other consoles working together with the console in which the gain of the microphone amplifier was adjusted.

### Summary

This need is met by the features of the independent claims. In the dependent claims preferred embodiments of the invention are described.

According to a first aspect of the invention, an audio console processing audio signals is provided comprising at least one input receiving an audio signal. Furthermore, an adjustable input amplifier is provided amplifying the audio signal received from said at least one input. Downstream of the adjustable input amplifier a direct out output is provided for outputting a direct out output signal. A direct out output amplifier provided between the adjustable input amplifier and the direct out output adjusts the gain of the direct out output signal. According to the invention, the direct out output amplifier is configured in such a way that, upon an adjustment of the adjustable input amplifier, the direct out output amplifier automatically adjusts the gain of the direct out output signal inversely to the adjustment of the input amplifier. This leads to an unchanged chain of the audio signal from said at least one input to the direct out output. Accordingly, when the user adjusts the gain of the adjustable input amplifier, which may be the microphone amplifier the signal provided at the direct out output is automatically adjusted the opposite number of dB thereby keeping the system gain from the source of the audio signal to the direct out output unchanged. An advantage of the embodiment of the present invention can be seen in the fact that the tracking of the gain is done within a single system avoiding issues with synchronizing the gain information to other systems and therefore improves reaction time. A further advantage is that the above-described audio console is not brand specific allowing to mix audio consoles of different providers.

Preferably, the direct out output amplifier is configured in such a way that its gain is set to unity if the adjustable input amplifier is not adjusted. In other words, when the user does not adjust the input amplifier the direct out output amplifier does normally neither increase nor decrease the signal strength of the received input signal. The direct output is preferably the earliest point of the signal chain of the audio console after the adjustable input amplifier. Especially, the direct out output signal is output before the signal is mixed to any other audio signal channel.

The invention furthermore relates to a console system processing audio signals comprising a master console and a slave console wherein the master console is configured as mentioned above having the direct output amplifier that inversely adjusts the gain in dependence on the adjustment of the adjustable input amplifier. The slave console furthermore comprises a digital source input connected to the direct out output of the master console. With this embodiment the slave console can share the received audio signal and the slave console does not have to pay attention to the fact whether the gain of the input audio signal was adjusted or not.

In another embodiment of the console system the slave console furthermore comprises an output connected to an additional input of the master console, the master console comprising an additional output and the transmission paths of the signal from the additional input to the additional output of the master console is preferably configured such that no further processing of the audio signal is carried out. However, it should be understood that an additional processing of the signal as received from the slave console before it is output from the master console can be carried out if needed. In another embodiment a hub is provided connected to an output of the master console and connected between the master console and a plurality of slave consoles. With such an embodiment multiple splits of the direct out output signal can be achieved.

The invention furthermore relates to a method for processing the audio signal in an audio console as mentioned above in which the adjustment of the gain of the adjustable input amplifier is monitored and if an adjustment of the gain of the input amplifier is detected, the gain of the direct out output signal is automatically inversely adjusted so as to keep the gain of the audio signal from the input to the output constant.

One major field of application of the invention is digital audio mixing consoles. However, the invention can also be applied to audio processing devices that can include configurable digital signal processors and where no actual mixing is carried out.

### Brief description of the drawings

In the following the invention will be described in further detail with reference to the accompanying drawings, in which
Fig. 1 shows a schematic view of the basic architecture of a console system keeping the gain of the direct out output signal constant,
Fig. 2 shows a schematic view of an embodiment of a master console and a slave console using the automatic adjustment of the direct out output signal,
Fig. 3 is a schematic view of another embodiment of the system shown in Fig. 1, in which a signal of the slave console is transmitted back to the master and transmitted unchanged to an additional unit, such as a stage rack, and
Fig. 4 shows an embodiment of the system, in which the master console is connected via a hub to multiple slave consoles.

### Detailed description

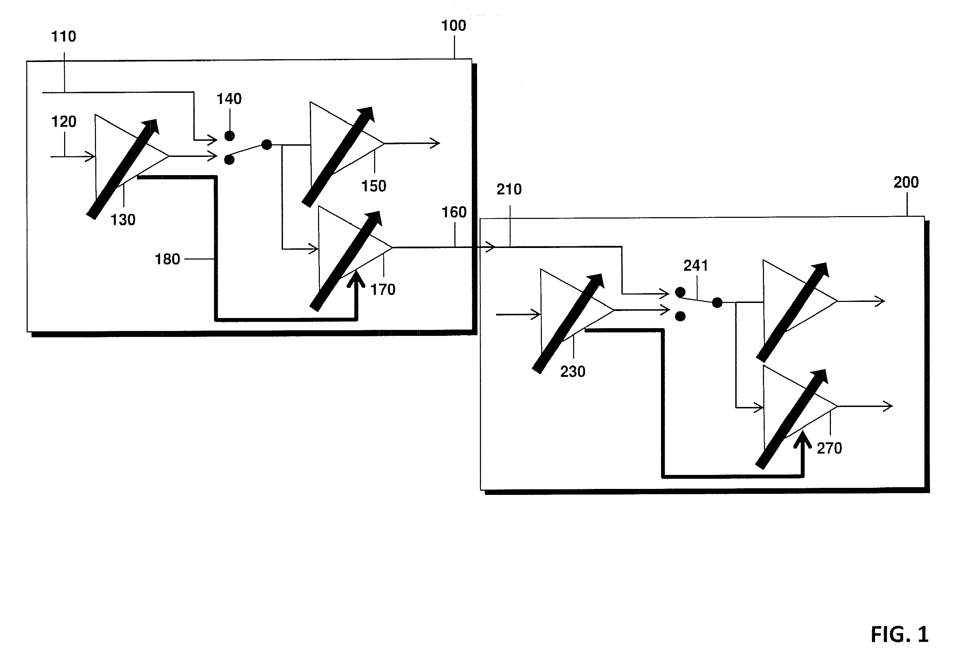

In the following, the invention will be described in connection with a audio mixing console. As shown in Fig. 1 a system is shown entaining a master console 100 and a slave console 200. The master console has several inputs for receiving different channels of audio signals, the master console having the control over the processing of the audio signals, the slave console 200 sharing the output of the master console. The master console 100 has an input 110 receiving a signal from a line or digital source, such as a keyboard. Furthermore, input 120 is provided where signals received from a microphone are received and transmitted to an adjustable input amplifier 130 or microphone amplifier. The input or microphone amplifier 130 may be located inside the master console 100 or may be provided remote of the master console. A source select switch 140 is provided which selectively transmits the signal from the input amplifier 130 or the line signal 110 to an amplifier 150 where a digital trim may be carried out and from where the signals are transmitted to the processing channels. In the console, like the console 100, a direct out output 160 is provided, the direct out output being a listening point within the channel path before it is mixed. Preferably, the direct out output is provided upstream of any kind of processing. The console 100 furthermore comprises a direct out output amplifier 170, this amplifier being a stage where the gain of the direct out output signal can be somehow controlled meaning that it may be amplified or attenuated. According to the invention, the direct out output amplifier 170 is related to the microphone amplifier or input amplifier 130 in such a way that it automatically reacts to the adjustment made at the input amplifier 130. The connection 180 shown in Fig. 1 indicates that the direct out output amplifier is controlled in such a way that it adjusts the gain of the direct out output signal in such a way that the system gain from the source that a direct out remains unchanged. The direct out output amplifier 170 monitors the gain adjustment of the input amplifier 130 and automatically adjusts the direct out output signal in such a way that no amplification or no attenuation of the signal at the direct out output 160 occurs. The direct out output signal is connected to a line or digital source input 210 of the slave console 200. With such an arrangement it can be assured that a gain adjustment of an operator made to the microphone amplifier 130 does not affect the levels of the audio signal at the other consoles such as the slave consoles. In case the slave console also receives analogue signal such as microphone signal, the slave console 200 can also comprise an input amplifier 230 that is analogue to the input amplifier 130 and a direct out output amplifier 270 that is adjusted in the same way as amplifier 170 of the master console. The slave also comprises a source select switch 241. However, under normal circumstances, only the master console receives the microphone signals.

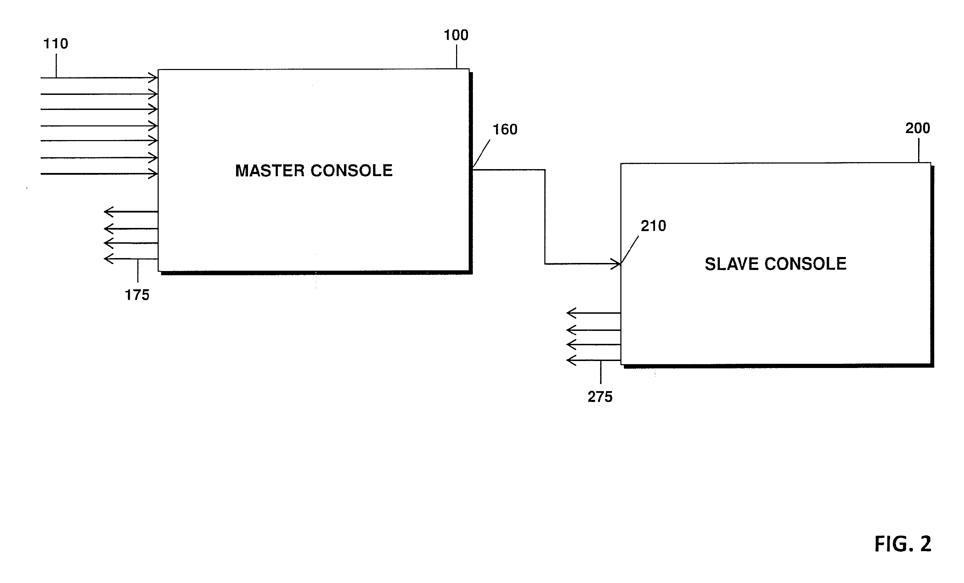

For the master and for the slave console the signal take-off point for the direct out output signal does not play an important role, but for the present application it will be the earliest point in the signal chain after the microphone amplifier. In Fig. 2 another embodiment of the system shown in Fig. 1 is shown in which the master console 100 receives a plurality of analogue inputs 110, e.g. received from sources from stage, the direct out output 160 being connected to the line input 210 as in the embodiment shown in Fig. 1. The slave console has additional outputs 275 that go to stage or to other units such as loudspeakers. In the same way, the master console has outputs 175 transmitting signals to stage or to loudspeakers.

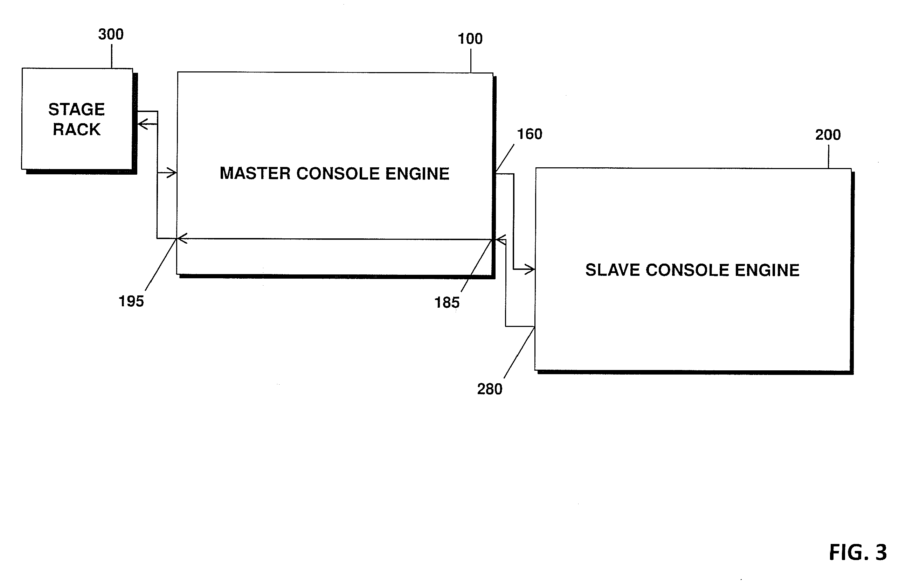

In Fig. 3 an embodiment is shown in which a stage rack 300 is provided, the stage rack receiving source signals from stage and providing multichannel links to the master console 100. The stage rack provides in and output points on stage. The direct out output signals which can be a multichannel direct out output signal that is automatically adjusted as described above, is received by the slave console, in input 280 the slave console transmitting back to the master console using input 185 and transmitted through an output 195 of the master console back to the stage rack. Preferably, the signals coming from the slave are passed through the master engine from input 185 to output 195 without processing. However, it should be understood that if needed, the signal may be further processed in the master console before it is transmitted back to the stage rack. The embodiment shown in Fig. 3 eliminates the need for any local input/output on the master or slave systems and eliminates all needs for an analogue multi core system.

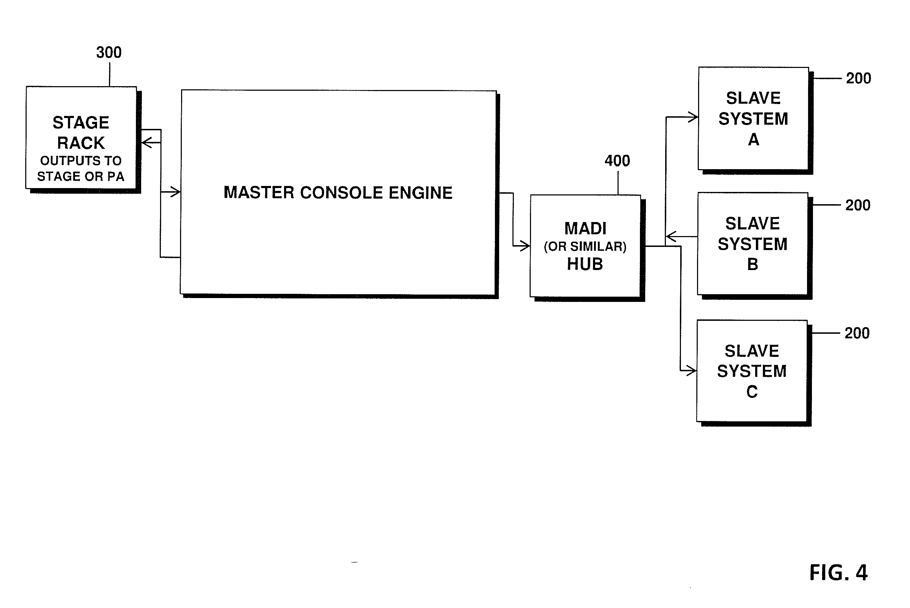

In Fig. 4 a slightly different embodiment compared to the embodiment of Fig. 3 is disclosed in which a hub 400 is provided. The hub may be a MADI hub or any similar hub, MADI (Multichannel Audio Digital Interface) being a standardized communication protocol defining data formats and electrical characteristics of an interface carrying multiple channels of digital audio. Using the hub 400 multiple splits of the direct out output signals of the master to several slave systems can be obtained. The splits can also be created using slave consoles daisy changed together with their inputs linked to outputs.

As can be seen from the above examples, the systems uses a direct out output from the master mixing console to stabilize the system rather than the input of the slave console. The stabilized signal level from the master console may be split or daisy changed an infinite number of times.

## Claims

1. An audio console (100) processing audio signals comprising:
- at least one input (120) receiving an audio signal,
- an adjustable input amplifier (130) amplifying the audio signal received from said at least one input,
- a direct out output (160) provided downstream of the adjustable input amplifier (130) for outputting a direct out output signal,
- a direct out output amplifier (170) provided upstream of the direct out output (160) and downstream of the adjustable input amplifier (130) for adjusting a gain of the direct out output signal, wherein the direct output amplifier (170) is configured in such a way, that, upon an adjustment of the adjustable input amplifier (130), the direct out output amplifier (170) adjusts the gain of the direct out output signal inversely to the adjustment of the input amplifier (130) resulting in an unchanged gain of the audio signal from said at least one input to the direct out output.

2. The audio console according to claim 1, wherein the direct out amplifier (170) is configured in such a way that its gain is set to unity if the adjustable input amplifier is not adjusted.

3. The audio console according to claim 1 or 2, wherein the direct out output (160) is the earliest point in the signal chain to the audio console (100) after the adjustable input amplifier (130).

4. The audio console according to any of the preceding claims, wherein the audio console is a digital audio mixing console.

5. A console system processing audio signals comprising a master console (100) and a slave console (200), the master console being a console as mentioned in any of claims 1 to 4, the slave console comprising a digital source input (210) connected to the direct out output (160) of the master console.

6. The console system according to claim 5, wherein the slave console (200) furthermore comprises an output (280) connected to an additional input (185) of the master, the master comprising an additional output (195) and a transmission path from the additional input to the additional output in which the audio signal is passed without further processing.

7. The console system according to claim 5 or 6, furthermore comprising a hub (400) connected to the direct out output (160) of the master, a plurality of slave consoles being connected to the hub (400).

8. A method for processing an audio signal in an audio console, the audio console comprising at least one input receiving the audio signal, an adjustable input amplifier amplifying the audio signal received from said at least one input, a direct out output provided downstream of the adjustable input amplifier for outputting a direct out output signal, a direct out output amplifier being provided upstream of the direct out output and downstream of the adjustable input amplifier for adjusting a gain of the direct out output signal,, the method comprising the steps of:
- monitoring an adjustment of the gain of the adjustable input amplifier, and if an adjustment of the gain of the input amplifier is detected, the gain of the direct out output signal is automatically inversely adjusted so as to keep the gain of the audio signal from the input to the direct output constant.
